# EUROPÄISCHE PATENTANMELDUNG

(11) **EP 4 404 453 A1**
(43) Veröffentlichungstag der Anmeldung: **24.07.2024**
(21) Anmeldenummer: 23152629.4
(22) Anmeldetag: 20.01.2023
(51) Int. Cl.: H02M 7/10, H02M 1/32

(54) **HOCHSPANNUNGSKASKADE**

(71) Anmelder: Siemens Healthineers AG, 91301 Forchheim (DE)
(72) Erfinder: Kraus, Michael, 91301 Forchheim (DE); Ludwig, Patrick, 91058 Erlangen (DE)
(74) Vertreter: Siemens Healthineers Patent Attorneys

(57) **Zusammenfassung**

Eine Hochspannungskaskade weist mehrere Kaskadenhalbstufen (3) auf, die jeweilige Stufeneingänge (4), jeweilige Stufenausgänge (5) und zwischen den jeweiligen Stufeneingängen (4) und den jeweiligen Stufenausgängen (5) eine jeweilige Kondensatorschaltung (6) und eine jeweilige Diodenschaltung (7) aufweisen. Die Stufeneingänge (4) der ersten Kaskadenhalbstufe (3) sind mit Eingangsanschlüssen (1) verbunden, über die der Hochspannungskaskade eine Eingangsspannung (Ue) zugeführt wird. Einer der Stufenausgänge (5) der letzten Kaskadenhalbstufe (3) ist mit einem von mehreren Ausgangsanschlüssen (2) verbunden, über die eine Ausgangsspannung (Ua) abgegeben wird. Im Übrigen sind die Stufenausgänge (5) einer jeweiligen Kaskadenhalbstufe (3) mit den Stufeneingängen (4) der jeweils nächsten Kaskadenhalbstufe (3) verbunden. Die Diodenschaltungen (7) sind auf ersten Zusatzplatinen (9) der Hochspannungskaskade angeordnet, die mit einer Hauptplatine (8) der Hochspannungskaskade elektrisch und mechanisch verbunden sind. Die ersten Zusatzplatinen (9) sind orthogonal zur Hauptplatine (8) orientiert und folgen entsprechend der elektrischen Abfolge der Kaskadenhalbstufen (3) in einer Erstreckungsrichtung (x) gesehen sequenziell aufeinander. Die ersten Zusatzplatinen (9) sind im Wesentlichen orthogonal zur Erstreckungsrichtung (x) orientiert. Die Kondensatorschaltungen (6) der Kaskadenhalbstufen (3) sind seitlich neben den ersten Zusatzplatinen (9) auf der Hauptplatine (8) angeordnet, und zwar entsprechend der elektrischen Abfolge der Kaskadenhalbstufen (3) und alternierend auf der einen und der anderen Seite der ersten Zusatzplatinen (9).

## Beschreibung

*Unabhängig vom grammatikalischen Geschlecht eines bestimmten Begriffes sind Personen mit männlicher, weiblicher oder anderer Geschlechteridentität mit umfasst.*

Die vorliegende Erfindung geht aus von einer Hochspannungskaskade,
- wobei die Hochspannungskaskade Eingangsanschlüsse aufweist, über die der Hochspannungskaskade eine Eingangsspannung zugeführt wird, und Ausgangsanschlüsse aufweist, über die eine Ausgangsspannung abgegeben wird,
- wobei die Hochspannungskaskade mehrere Kaskadenhalbstufen aufweist,
- wobei die Kaskadenhalbstufen jeweilige Stufeneingänge, jeweilige Stufenausgänge und zwischen den jeweiligen Stufeneingängen und den jeweiligen Stufenausgängen eine jeweilige Kondensatorschaltung und eine jeweilige Diodenschaltung aufweisen,
- wobei die Stufeneingänge der ersten Kaskadenhalbstufe mit den Eingangsanschlüssen verbunden sind, einer der Stufenausgänge der letzten Kaskadenhalbstufe mit einem der Ausgangsanschlüsse verbunden ist und im Übrigen die Stufenausgänge einer jeweiligen Kaskadenhalbstufe mit den Stufeneingängen der jeweils nächsten Kaskadenhalbstufe verbunden sind, so dass die Kaskadenhalbstufen eine elektrische Abfolge von Kaskadenhalbstufen bilden.

Hochspannungskaskaden sind allgemein bekannt. Rein beispielhaft kann auf die sogenannte Villard-Schaltung verwiesen werden. Auch die Greinacher-Schaltung und die Delon-Schaltung können genannt werden.

In vielen Fällen muss eine Hochspannung bereitgestellt werden, um bestimmte Einrichtungen ordnungsgemäß betreiben zu können. Beispielsweise werden Hochspannungen für den Betrieb von Röntgenröhren, Teilchenbeschleunigern, elektrostatischen Staubfiltern, Ionisatoren und anderen mehr benötigt. Die Hochspannung kann - je nach Anwendungsfall - im Bereich von wenigen kV bis im Bereich von mehreren MV liegen.

Die Technologie zum Erzeugen einer derartigen Hochspannung ist - insbesondere in Form der obenstehend genannten Schaltungen - etabliert und bewährt. Von Nachteil ist jedoch, dass die Hochspannungskaskaden oftmals einen großen Bauraum benötigen.

In manchen Fällen ist der benötigte Bauraum unproblematisch. Beispiele derartiger Anwendungsfälle sind insbesondere Teilchenbeschleuniger und industrielle Anwendungen. In anderen Fällen ist eine kompakte Bauweise der Hochspannungskaskade essenziell. Beispiele derartiger Anwendungsfälle sind insbesondere Röntgenröhren in medizintechnischen Anlagen. Ein typisches Beispiel einer derartigen medizintechnischen Anlage ist eine C-Bogen-Anlage. Ein weiteres typisches Beispiel ist eine CT-Anlage. In beiden Fällen ist die Röntgenröhre der medizintechnischen Anlage in einem bewegten Element angeordnet, so dass auch die Hochspannungskaskade in dem bewegten Element angeordnet sein muss.

Die Aufgabe der vorliegenden Erfindung besteht darin, eine Hochspannungskaskade zu schaffen, die nur einen geringen Bauraum benötigt.

Die Aufgabe wird durch eine Hochspannungskaskade mit den Merkmalen des Anspruchs 1 gelöst. Vorteilhafte Ausgestaltungen der Hochspannungskaskade sind Gegenstand der abhängigen Ansprüche 2 bis 14.

Erfindungsgemäß wird eine Hochspannungskaskade der eingangs genannten Art dadurch ausgestaltet,
- dass die Diodenschaltungen der Kaskadenhalbstufen jeweils auf einer eigenen ersten Zusatzplatine der Hochspannungskaskade angeordnet sind, die mit einer Hauptplatine der Hochspannungskaskade elektrisch und mechanisch verbunden sind,
- dass die ersten Zusatzplatinen orthogonal zur Hauptplatine orientiert sind und entsprechend der elektrischen Abfolge der Kaskadenhalbstufen in einer Erstreckungsrichtung gesehen sequenziell aufeinander folgend angeordnet sind,
- dass die ersten Zusatzplatinen im Wesentlichen orthogonal zur Erstreckungsrichtung orientiert sind und
- dass die Kondensatorschaltungen der Kaskadenhalbstufen seitlich neben den ersten Zusatzplatinen auf der Hauptplatine angeordnet sind, und zwar entsprechend der elektrischen Abfolge der Kaskadenhalbstufen und alternierend auf der einen und der anderen Seite der ersten Zusatzplatinen.

Dadurch wird ein sehr kompakter Aufbau erreicht, der dennoch eine hohe Spannungsfestigkeit aufweist.

Die Eingangsspannung, also die der Hochspannungskaskade zugeführte Spannung, ist eine Wechselspannung. Sie ist in der Regel bereits selbst eine Hochspannung (d.h. eine Spannung oberhalb von 1000 V). In vielen Fällen wird die Eingangsspannung ausgangsseitig eines Transformators abgegriffen. Die dem Transformator eingangsseitig zugeführte Spannung ist in diesem Fall oftmals eine Niederspannung, d.h. eine Spannung unterhalb von 1000 V. Beispielsweise kann es sich um eine übliche Haushaltsspannung (100 V, 110 V, 230 V, in Ausnahmefällen 400 V) handeln.

Die Ausgangsspannung ist eine Gleichspannung, deren Wert oberhalb des Scheitelwerts der Eingangsspannung liegt, meist deutlich oberhalb des Scheitelwerts der Eingangsspannung. Die Ausgangsspannung kann - beispielsweise - im Bereich zwischen 80 kV und 150 kV liegen. Sie kann aber auch einen anderen Wert aufweisen.

Aufgrund ihrer Funktionalität müssen die Hauptplatine und die ersten Zusatzplatinen hochspannungsfest sein. Die ersten Zusatzplatinen können mit der Hauptplatine gelötet sein. Alternativ können sie beispielsweise in die Hauptplatine eingesteckt sein. Sowohl das Erfordernis der Hochspannungsfestigkeit als auch die möglichen Arten der Verbindung mit der Hauptplatine (gelötet oder eingesteckt) gelten auch für eventuell vorhandene weitere Zusatzplatinen.

Die Anzahl an ersten Zusatzplatinen kann nach Bedarf gewählt sein. Beispielsweise kann sie bei 10, 20 oder 30 liegen. Auch Werte unterhalb von 10 oder oberhalb von 30 sind möglich. Die Anzahl an ersten Zusatzplatinen ist jedoch gerade.

Die Diodenschaltungen, also die auf einer der ersten Zusatzplatinen angeordneten Schaltungen, umfassen meist eine Reihenschaltung von Dioden. Die Anzahl an in Reihe geschalteten Dioden liegt oftmals zwischen 20 und 100, insbesondere zwischen 40 und 70. Die Anzahl an in Reihe geschalteten Dioden kann aber auch größer oder kleiner als die genannten Werte sein. Weiterhin sind auch andere Ausgestaltungen möglich. Beispielsweise können die Diodenschaltungen mehrere Stränge aufweisen, wobei pro Strang mehrere Dioden in Reihe geschaltet sind. Die Verschaltung der Stränge miteinander - beispielsweise (im elektrischen Sinne) parallel zueinander - kann je nach Lage des Einzelfalls durch eine entsprechende Führung von Leiterbahnen auf den ersten Zusatzplatinen oder durch eine entsprechende Führung von Leiterbahnen auf der Hauptplatine erfolgen.

Der Begriff "im Wesentlichen orthogonal zur Erstreckungsrichtung orientiert" soll kleinere Abweichungen von der exakten Orthogonalität mit umfassen. Eine kleinere Abweichung liegt vor, wenn und solange der Winkel zwischen der Erstreckungsrichtung und der Normalen der jeweiligen ersten Zusatzplatine maximal 15° beträgt. Oftmals ist der Winkel sogar erheblich kleiner als 15°, beispielsweise maximal 12°, maximal 10° oder maximal 8°. Die, bezogen auf die Erstreckungsrichtung, nur im wesentlichen orthogonale Orientierung der ersten Zusatzplatinen steht auch in einem Gegensatz zur Orientierung orthogonal zur Hauptplatine. Denn diese Orientierung ist - mit Ausnahme von unvermeidbaren Ungenauigkeiten - exakt orthogonal.

Vorzugsweise sind die ersten Zusatzplatinen auf der Hauptplatine zickzackförmig angeordnet. Durch diese Ausgestaltung kann insbesondere eine Leitungsführung der Hauptplatine erreicht werden, bei welcher die Leitungen zu unterschiedliche Potenziale führenden Kondensatorschaltungen trotz der kompakten Bauweise weit voneinander beabstandet sein können.

Bei der zickzackförmigen Anordnung sind die ersten Zusatzplatinen zwangsweise nur im Wesentlichen orthogonal, nicht aber exakt zur Erstreckungsrichtung orientiert. Der Winkel zwischen der Erstreckungsrichtung und der Normalen der jeweiligen ersten Zusatzplatine beträgt in diesem Fall vorzugsweise mindestens 3°, insbesondere mindestens 5°. Er kann auch bei einem größeren Wert liegen, insbesondere bei bis zu 10° oder sogar bei bis zu 15°.

Vorzugsweise sind in die Hauptplatine zwischen aufeinanderfolgenden ersten Zusatzplatinen erste Ausnehmungen eingebracht. Durch diese Ausgestaltung kann die Spannungsfestigkeit der Hochspannungskaskade erhöht werden. Im Falle der zickzackförmigen Anordnung der ersten Zusatzplatinen können die ersten Ausnehmungen insbesondere dreieckförmig sein.

Vorzugsweise sind in die Hauptplatine im Bereich von Kondensatoren der Kondensatorschaltungen zweite Ausnehmungen eingebracht, so dass die jeweilige zweite Ausnehmung zwischen Anschlüssen des jeweiligen Kondensators angeordnet ist. Auch durch diese Ausgestaltung kann die Spannungsfestigkeit der Hochspannungskaskade erhöht werden.

Vorzugsweise weist die Hochspannungskaskade zweite Zusatzplatinen auf, die mit der Hauptplatine elektrisch und mechanisch verbunden sind. In diesem Fall ist je eine der zweiten Zusatzplatinen zwischen jeweils zwei aufeinander folgenden ersten Zusatzplatinen angeordnet und ist weiterhin die jeweilige zweite Zusatzplatine mit einem Ausgangspotenzial der Kaskadenhalbstufe verbunden, deren Bestandteil die jeweils vordere erste Zusatzplatine ist. Durch die zweiten Zusatzplatinen wird erreicht, dass die ersten Zusatzplatinen und damit die Diodenschaltungen sich in einem definierten elektrischen Feld - im Gegensatz zu einem sich zufällig einstellenden elektrischen Feld - befinden. Aufgrund des definierten elektrischen Feldes ergeben sich vor allem im Falle eines plötzlichen Zusammenbruchs der Ausgangsspannung verbesserte Entladungen der Diodenschaltungen. Damit wird die Betriebssicherheit der Hochspannungskaskade erhöht.

Die zweiten Zusatzplatinen können, sofern in die Hauptplatine zwischen den ersten Zusatzplatinen die ersten Ausnehmungen eingebracht sind, insbesondere die ersten Ausnehmungen überbrücken, also links und rechts der jeweiligen ersten Ausnehmung mit der Hauptplatine verbunden sein.

Aufgrund des Umstands, dass mittels der zweiten Zusatzplatinen die elektrischen Felder für die ersten Zusatzplatinen eingestellt werden, können die zweiten Zusatzplatinen auch als Feldführungsplatinen, Feldsteuerplatinen oder Potenzialsteuerplatinen bezeichnet werden.

Vorzugsweise ist folgend auf die erste Zusatzplatine der letzten Kaskadenhalbstufe eine weitere zweite Zusatzplatine angeordnet, wobei die weitere zweite Zusatzplatine mit einem Ausgangspotenzial der letzten Kaskadenhalbstufe verbunden ist. Dadurch befindet sich auch die erste Zusatzplatine, welche die Diodenschaltung der letzten Kaskadenhalbstufe trägt, in einem definierten elektrischen Feld.

Die zweiten Zusatzplatinen sind weiterhin vorzugsweise orthogonal zur Erstreckungsrichtung orientiert. Dies vereinfacht insbesondere das Layout der Hauptplatine.

Vorzugsweise weist die Hochspannungskaskade eine dritte Zusatzplatine auf, die mit der Hauptplatine elektrisch und mechanisch verbunden ist. In diesem Fall sind die Eingangsanschlüsse auf der dritten Zusatzplatine angeordnet. Durch diese Ausgestaltung kann die Zuführung der Eingangsspannung zu der Hochspannungskaskade vereinfacht und optimiert werden.

Die dritte Zusatzplatine ist weiterhin vorzugsweise orthogonal zur Erstreckungsrichtung orientiert. Dies vereinfacht insbesondere das Layout der Hauptplatine.

Die dritte Zusatzplatine kann in der Erstreckungsrichtung gesehen alternativ am Rand der Hauptplatine oder in der Mitte der Hauptplatine angeordnet sein. Im einen Fall erstrecken sich die ersten und gegebenenfalls auch zweiten Zusatzplatinen nur ausgehend von einer Seite der dritten Zusatzplatine, im anderen Fall erstreckt sich ausgehend von beiden Seiten der dritten Zusatzplatinen jeweils eine Sequenz von ersten und gegebenenfalls auch zweiten Zusatzplatinen.

Es ist möglich, dass die Hochspannungskaskade mindestens eine vierte Zusatzplatine aufweist, die mit der Hauptplatine elektrisch und mechanisch verbunden ist. In diesem Fall trägt die vierte Zusatzplatine eine Teilerschaltung. Die Teilerschaltung weist einerseits Messanschlüsse auf, die jeweils mit einem der Stufeneingänge und einem der Stufenausgänge - nicht notwendigerweise derselben Kaskadenhalbstufe - verbunden sind. Weiterhin weist die Teilerschaltung in diesem Fall andererseits Ausgabeanschlüsse auf, über die ein Bruchteil einer über die Messanschlüsse abgegriffenen Kaskadenspannung als Messspannung abgreifbar ist. Durch diese Ausgestaltung ist auf einfache Art und Weise ein Abgriff einer Messspannung möglich. Die Bezeichnung der abgegriffenen Spannung als Kaskadenspannung und der ausgegebenen Spannung als Messspannung dient lediglich der sprachlichen Unterscheidung sowie der Charakterisierung, dass die eine Spannung auf Seiten der Hochspannungskaskade abgegriffen wird und die andere Spannung eine Messgröße darstellt, die ausgegeben wird. Eine weitergehende Bedeutung kommt den beiden Begriffen nicht zu.

Alternativ oder zusätzlich ist es auch möglich, dass die Hochspannungskaskade mindestens eine fünfte Zusatzplatine aufweist, die mit der Hauptplatine elektrisch und mechanisch verbunden ist. In diesem Fall weist die fünfte Zusatzplatine eine Schaltung von Bauelementen auf, über welche die Kondensatorschaltungen entladen werden, sobald der Hochspannungskaskade über die Eingangsanschlüsse nicht mehr die Eingangsspannung zugeführt wird. Durch diese Ausgestaltung wird auf konstruktiv einfache und auch kompakte Art und Weise der allmähliche Abbau einer einmal generierten Hochspannung gewährleistet. Die Schaltung von Bauelementen kann eine sogenannte Lebensretterschaltung bilden. Oftmals handelt es sich bei den Bauelementen um ohmsche Widerstände, die Widerstandswerte von etlichen Megaohm aufweisen.

Vorzugsweise weist die Hochspannungskaskade ein Ölbad auf, in dem die Hauptplatine und die ersten Zusatzplatinen angeordnet sind. Dadurch kann die Spannungsfestigkeit der Hochspannungskaskade erhöht werden.

Soweit vorhanden, sind zusätzlich zur Hauptplatine und den ersten Zusatzplatinen auch die zweiten Zusatzplatinen, die dritte Zusatzplatine, die vierten Zusatzplatinen (hier meist mit Ausnahme der Ausgabeanschlüsse) und die fünften Zusatzplatinen in dem Ölbad angeordnet.

Vorzugsweise weist die Hauptplatine in der Erstreckungsrichtung gesehen hinter der ersten Zusatzplatine der letzten Kaskadenhalbstufe eine sich in der Erstreckungsrichtung erstreckende Zunge auf, wobei einer der Ausgangsanschlüsse an dem von der ersten Zusatzplatine der letzten Kaskadenhalbstufe beabstandeten Ende der Zunge angeordnet ist. Durch diese Ausgestaltung kann die Spannungsfestigkeit der Hochspannungskaskade erhöht werden.

Vorzugsweise wird die Hochspannungskaskade für die elektrische Energieversorgung einer Röntgenröhre einer medizintechnischen Anlage verwendet, insbesondere einer C-Bogen-Anlage oder einer CT-Anlage. Insbesondere bei derartigen Anlagen steht oftmals nur ein sehr geringer Bauraum für die Hochspannungskaskade zur Verfügung.

Mit der elektrischen Energieversorgung der Röntgenröhre ist im vorliegenden Fall natürlich nicht eine "normale" Energieversorgung gemeint, die beispielsweise bei einer Röntgenröhre mit einer Drehanode für den Antrieb der Drehanode benötigt wird, sondern die Energieversorgung, die für das Erzeugen der Röntgenstrahlung als solcher benötigt wird, also für die Spannung, die zwischen Kathode und Anode der Röntgenröhre anliegt.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: ein Blockschaltbild einer Hochspannungskaskade,
- FIG 2: ein Blockschaltbild dreier aufeinanderfolgender Kaskadenhalbstufen,
- FIG 3: eine perspektivische Ansicht einer Hochspannungskaskade,
- FIG 4: eine Explosionsdarstellung der Hochspannungskaskade von FIG 3,
- FIG 5: eine Draufsicht auf die Hochspannungskaskade von FIG 3,
- FIG 6: ein Layout einer Hauptplatine,
- FIG 7: eine schematische Ansicht einer Hochspannungskaskade von der Seite,
- FIG 8: eine vierte Zusatzplatine und
- FIG 9: eine fünfte Zusatzplatine.

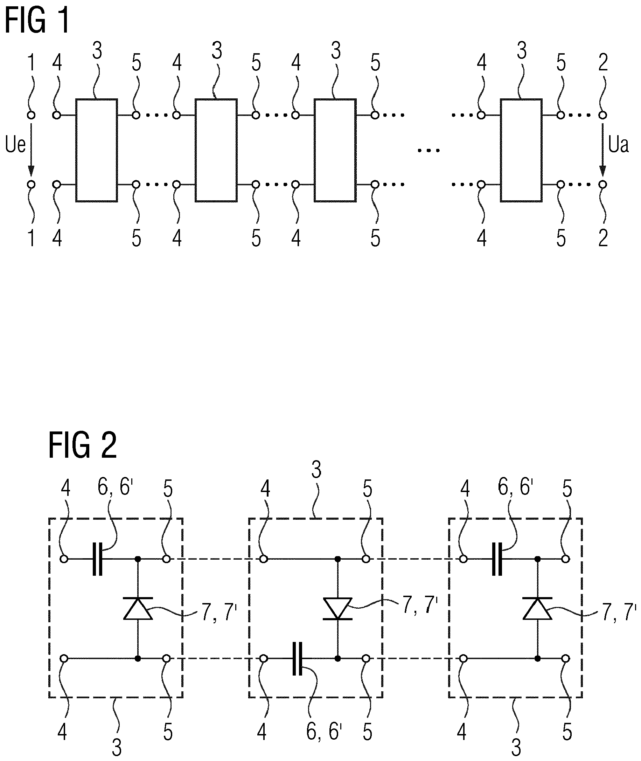

Gemäß FIG 1 weist eine Hochspannungskaskade Eingangsanschlüsse 1 auf. Über die Eingangsanschlüsse 1 kann der Hochspannungskaskade eine Eingangsspannung Ue zugeführt werden. Die Eingangsspannung Ue ist in der Regel eine Wechselspannung und eine Hochspannung, also eine Spannung oberhalb von 1000 V. Die Eigenschaft "Hochspannung" ist aber nicht zwingend erforderlich.

Die Hochspannungskaskade weist weiterhin Ausgangsanschlüsse 2 auf. Über die Ausgangsanschlüsse 2 wird eine Ausgangsspannung Ua abgegeben. Die Ausgangsspannung Ua ist stets eine Gleichspannung und stets eine Hochspannung. Sie ist weiterhin stets größer als der Scheitelwert der Eingangsspannung Ue. Oftmals liegt die Ausgangsspannung Ua im Bereich von etwa 100 kV. Der Bereich der Hochspannung ist aber nicht zwingend erforderlich.

Die Hochspannungskaskade weist weiterhin mehrere Kaskadenhalbstufen 3 auf. Die Kaskadenhalbstufen 3 folgen in elektrischer Hinsicht sequenziell aufeinander, bilden also eine elektrische Abfolge von Kaskadenhalbstufen 3. Insbesondere weisen die Kaskadenhalbstufen 3 jeweilige Stufeneingänge 4 und jeweilige Stufenausgänge 5 auf. Die Stufeneingänge 4 der vordersten Kaskadenhalbstufe 3 (d.h. der ersten Kaskadenhalbstufe 3) sind mit den Eingangsanschlüssen 1 verbunden. Einer der Stufenausgänge 5 der letzten Kaskadenhalbstufe 3 ist mit einem der Ausgangsanschlüsse 2 verbunden. Der andere Ausgangsanschluss 2 kann nach Bedarf mit einem definierten Potenzial verbunden sein, insbesondere durch eine Masseverbindung. Im Übrigen sind die Stufenausgänge 5 einer jeweiligen Kaskadenhalbstufe 3 mit den Stufeneingängen 4 der jeweils nächsten Kaskadenhalbstufe 3 verbunden.

Soweit nachfolgend auf die erste Kaskadenhalbstufe 3, die zweite Kaskadenhalbstufe 3 usw. Bezug genommen wird, ist die jeweilige Kaskadenhalbstufe 3 entsprechend der elektrischen Abfolge von Kaskadenhalbstufen 3 gemeint.

Die Kaskadenhalbstufen 3 weisen gemäß FIG 2 zwischen den jeweiligen Stufeneingängen 4 und den jeweiligen Stufenausgängen 5 eine Kondensatorschaltung 6 und eine Diodenschaltung 7 auf.

Eingezeichnet ist in FIG 2 jeweils nur ein einzelner Kondensator 6' für die Kondensatorschaltung 6 und eine einzelne Diode 7' für die Diodenschaltung 7. Dies ist jedoch nicht beschränkend zu verstehen. Es kann sich um eine - prinzipiell beliebige Kombination einer Serien- und/oder Parallelschaltung von Kondensatoren 6' bzw. Dioden 7' handeln.

Bisher wurde der elektrische Aufbau der Hochspannungskaskade erläutert. Dieser Aufbau ist als solcher bekannt. Nunmehr wird in Verbindung mit den weiteren FIG auf den mechanischkonstruktiven Aufbau der Hochspannungskaskade eingegangen. Der mechanisch-konstruktive Aufbau stellt den Kerngegenstand der vorliegenden Erfindung dar.

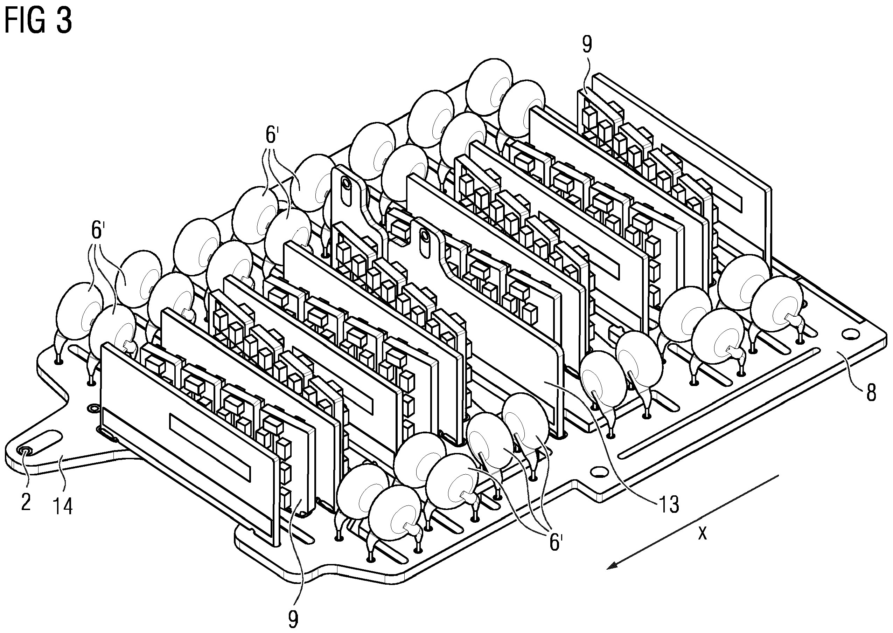

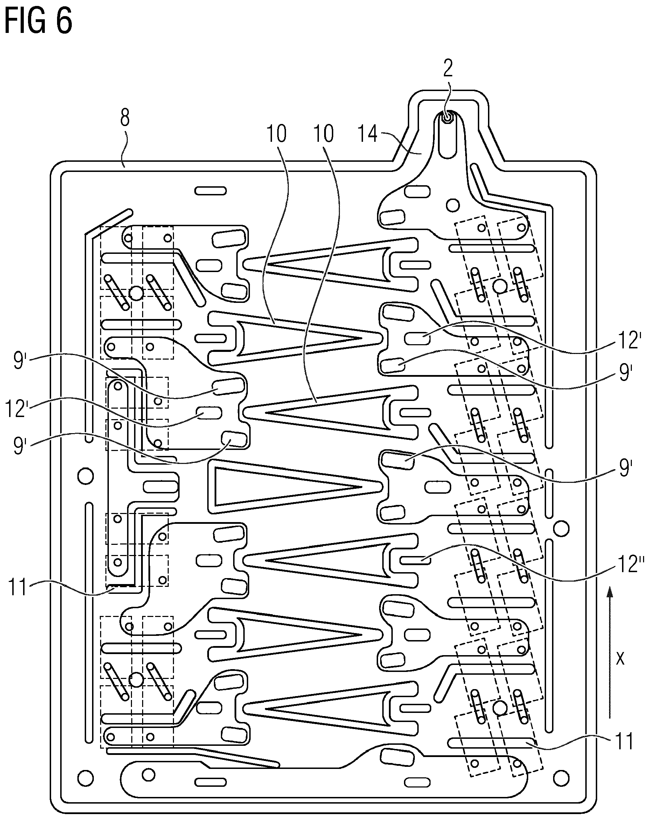

Die FIG 3 bis 5 zeigen verschiedene Ansichten derselben mechanisch-konstruktiven Ausgestaltung einer erfindungsgemäßen Hochspannungskaskade. FIG 6 zeigt das zugehörige Layout einer Hauptplatine 8 der Hochspannungskaskade. Die Hauptplatine 8 dient (unter anderem) als Trägerplatine für weitere Platinen. Die FIG 3 bis 6 werden nachstehend gemeinsam erläutert.

Eine Gruppe von weiteren Platinen sind erste Zusatzplatinen 9. Die Bezeichnung dieser Zusatzplatinen als erste Zusatzplatinen 9 dient nicht der Kennzeichnung einer Abfolge, sondern der sprachlichen Unterscheidung von später noch eingeführten weiteren Zusatzplatinen. Auch bei den später noch eingeführten weiteren Zusatzplatinen dient die entsprechende Bezeichnung als zweite, dritte usw. Zusatzplatinen nicht der Kennzeichnung einer Abfolge, sondern der sprachlichen Unterscheidung von den anderen Zusatzplatinen. In den FIG 3 bis 5 sind der Übersichtlichkeit halber nur einige der ersten Zusatzplatinen 9 mit ihrem Bezugszeichen versehen.

Die ersten Zusatzplatinen 9 sind orthogonal zur Hauptplatine 8 orientiert und mit der Hauptplatine 8 elektrisch und mechanisch verbunden, also auf der Hauptplatine 8 angeordnet. Mit dem Bezugszeichen 9' sind in FIG 6 für zwei aufeinanderfolgende der ersten Zusatzplatinen 9 die entsprechenden Verbindungsstellen bezeichnet.

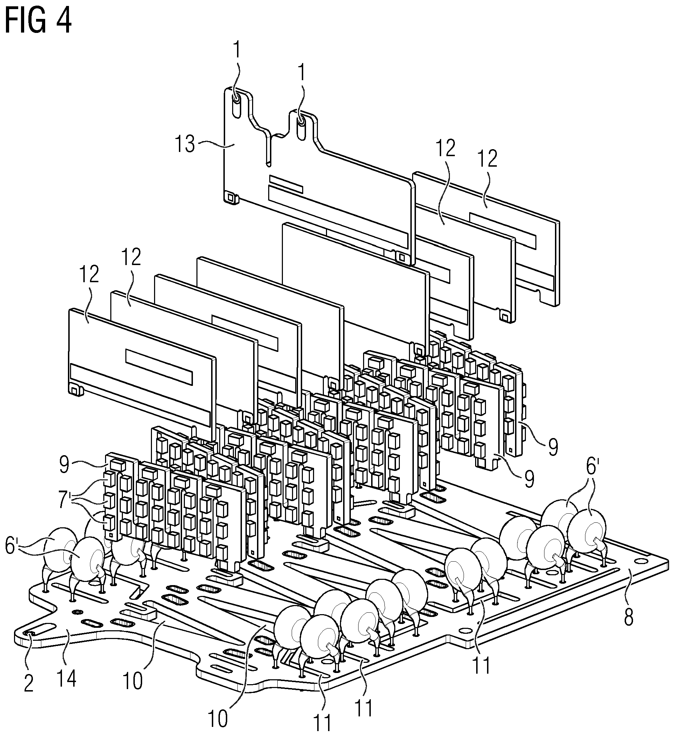

Auf den ersten Zusatzplatinen 9 ist jeweils die Diodenschaltung 7 einer Kaskadenhalbstufe 3 angeordnet. Hierbei besteht in der Regel eine 1:1-Zuordnung. Die Anzahl an ersten Zusatzplatinen 9 stimmt also mit der Anzahl an Kaskadenhalbstufen 3 überein. Aus den Darstellungen der FIG 3 bis 5 ist auch erkennbar, dass die ersten Zusatzplatinen 9 eine Vielzahl von einzelnen Bauelementen tragen. Jedes derartige Bauelement ist in der Regel eine Diode 7'. Rein beispielhaft sind in FIG 4 einige der Dioden 7' mit ihrem Bezugszeichen versehen.

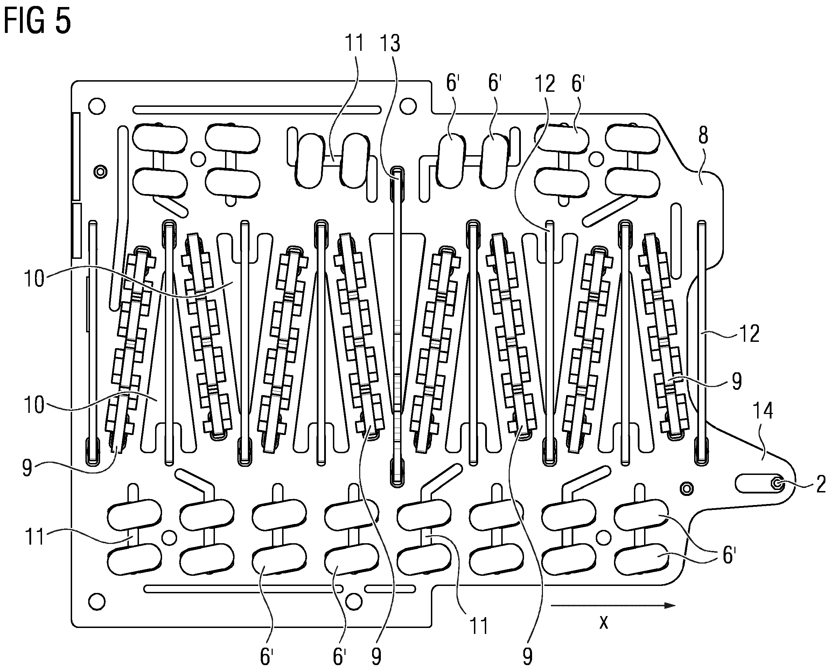

Die ersten Zusatzplatinen 9 folgen in einer Erstreckungsrichtung x gesehen entsprechend der elektrischen Abfolge der Kaskadenhalbstufen 3 sequenziell aufeinander. Die Erstreckungsrichtung x liegt innerhalb der durch die Hauptplatine 8 definierten Ebene. Die Zusatzplatine 9, auf der die Diodenschaltung 7 der i-ten Kaskadenhalbstufe 3 angeordnet ist, folgt also in der Erstreckungsrichtung x gesehen unmittelbar auf die Zusatzplatine 9 der (i-1)-ten Kaskadenhalbstufe 3, wobei i = 2, ... n gilt und n die Anzahl an Kaskadenhalbstufen 3 bezeichnet. Die Formulierung "unmittelbar folgt" bedeutet in diesem Zusammenhang, dass sich zwischen den beiden genannten ersten Zusatzplatinen 9 keine andere erste Zusatzplatine 9 befindet. Ersichtlich sind die ersten Zusatzplatinen 9 im Wesentlichen orthogonal zur Erstreckungsrichtung x orientiert. Oftmals bilden sie, wie besonders deutlich aus FIG 5 ersichtlich ist, mit der Erstreckungsrichtung x jedoch einen Winkel, der geringfügig (maximal um 15°) von der Orthogonalen abweicht. Eine derartige Abweichung von der Orthogonalen ist zwar nicht zwingend. Sie kann aber insbesondere dann sinnvoll sein, wenn die ersten Zusatzplatinen 9, wie ebenfalls aus FIG 5 ersichtlich, auf der Hauptplatine 8 zickzackförmig angeordnet sind.

Die Kondensatorschaltungen 6 der Kaskadenhalbstufen 3 sind gemäß den FIG 3 bis 6 auf der Hauptplatine 8 angeordnet, und zwar zum einen seitlich neben den ersten Zusatzplatinen 9 und zum anderen entsprechend der elektrischen Abfolge der Kaskadenhalbstufen 3. Weiterhin sind die Kondensatorschaltungen 6 alternierend auf der einen und der anderen Seite der ersten Zusatzplatinen 9 angeordnet. Die Kondensatoren 6' der Kondensatorschaltungen 6 der ersten, der dritten, der fünften usw. Kaskadenhalbstufe 3 sind also auf der einen Seite der ersten Zusatzplatinen 9 angeordnet, die Kondensatoren 6' der Kondensatorschaltungen 6 der zweiten, der vierten, der sechsten usw. Kaskadenhalbstufe 3 auf der anderen Seite. In den FIG 3 bis 5 sind der Übersichtlichkeit halber nur einige der Kondensatoren 6' mit ihrem Bezugszeichen versehen.

Aus den FIG 3 bis 6 ist auch eine Vielzahl von vorteilhaften Ausgestaltungen der Hochspannungskaskade erkennbar. Diese Ausgestaltungen sind, soweit sie nicht direkt und unmittelbar aufeinander aufbauen, unabhängig voneinander realisierbar.

So sind gemäß den FIG 3 bis 6 in die Hauptplatine 8 erste Ausnehmungen 10 eingebracht. Konkret befindet sich jeweils eine erste Ausnehmung 10 zwischen zwei aufeinanderfolgenden ersten Zusatzplatinen 9. Die ersten Ausnehmungen 10 sind vorliegend im wesentlichen dreieckförmig ausgebildet. Diese Ausgestaltung ist eine Folge der zickzackförmigen Anordnung der ersten Zusatzplatinen 9. In den FIG 4 bis 6 sind der Übersichtlichkeit halber nur einige der ersten Ausnehmungen 10 mit ihrem Bezugszeichen versehen.

Weiterhin sind gemäß den FIG 4 bis 6 in die Hauptplatine 8 zweite Ausnehmungen 11 eingebracht. Die zweiten Ausnehmungen 11 sind im Bereich der Kondensatoren 6' der Kondensatorschaltungen 6 angeordnet. Die Anordnung ist derart, dass die jeweilige zweite Ausnehmung 11 zwischen Anschlüssen des jeweiligen Kondensators 6' der jeweiligen Kondensatorschaltung 6 angeordnet ist. In den FIG 4 bis 6 sind der Übersichtlichkeit halber nur einige der zweiten Ausnehmungen 11 mit ihrem Bezugszeichen versehen.

Die Bezeichnung der Ausnehmungen 10, 11 als erste und zweite Ausnehmungen 10, 11 dient, ebenso wie bei den Zusatzplatinen, nicht der Kennzeichnung einer Abfolge, sondern der sprachlichen Unterscheidung der Ausnehmungen 10, 11 voneinander.

Weiterhin weist die Hochspannungskaskade gemäß den FIG 3 bis 5 als weitere Platinen zweite Zusatzplatinen 12 auf. In den FIG 4 und 5 sind der Übersichtlichkeit halber nur einige der zweiten Zusatzplatinen 12 mit ihrem Bezugszeichen versehen.

Die zweiten Zusatzplatinen 12 sind mit der Hauptplatine 8 elektrisch und mechanisch verbunden, also auf der Hauptplatine 8 angeordnet. Ersichtlich ist je eine der zweiten Zusatzplatinen 12 zwischen jeweils zwei aufeinander folgenden ersten Zusatzplatinen 9 angeordnet. Die jeweilige zweite Zusatzplatine 12 ist mit einem Ausgangspotenzial der Kaskadenhalbstufe 3 verbunden, deren Bestandteil die jeweils vordere erste Zusatzplatine 9 ist. Mit dem Bezugszeichen 12' sind in FIG 6 für einige der zweiten Zusatzplatinen 12 die entsprechenden Verbindungsstellen bezeichnet. Die entsprechende zweite Zusatzplatine 12 ist also mit einem der Stufenausgänge 5 der entsprechenden Kaskadenhalbstufe 3 verbunden. Aus den FIG 3 bis 5 ist weiterhin ersichtlich, dass auch auf die erste Zusatzplatine 9 der letzten Kaskadenhalbstufe 3 eine weitere zweite Zusatzplatine 12 folgt. Diese weitere zweite Zusatzplatine 12 ist mit einem Ausgangspotenzial der letzten Kaskadenhalbstufe 3 verbunden.

Die zweiten Zusatzplatinen 12 sind vorzugsweise orthogonal zur Erstreckungsrichtung x orientiert. Die zweiten Zusatzplatinen 12 tragen keine Schaltung, sondern bilden lediglich Trennflächen zur elektrischen Abschirmung der ersten Zusatzplatinen 9. Auf der der jeweiligen Verbindungsstelle 12' gegenüberliegenden Seite der Hauptplatine 8 ist daher lediglich eine rein mechanische Verbindung der zweiten Zusatzplatinen 12 mit der Hauptplatine 8 erforderlich. In FIG 6 ist exemplarisch eine dieser rein mechanischen Verbindungsstellen mit dem Bezugszeichen 12" bezeichnet.

Weiterhin weist die Hochspannungskaskade gemäß den FIG 3 bis 5 als weitere Platine eine dritte Zusatzplatine 13 auf. Auch die dritte Zusatzplatine 13 ist mit der Hauptplatine 8 elektrisch und mechanisch verbunden, also auf der Hauptplatine 8 angeordnet. Auf der dritten Zusatzplatine 13 sind die Eingangsanschlüsse 1 angeordnet. Die dritte Zusatzplatine 13 ist - analog zu den zweiten Zusatzplatinen 12 - vorzugsweise orthogonal zur Erstreckungsrichtung x orientiert.

Die dritte Zusatzplatine 3 ist gemäß den FIG 3 bis 5 in der Erstreckungsrichtung x gesehen zentral angeordnet, das heißt dass ausgehend von der dritten Zusatzplatine 13 in der Erstreckungsrichtung x gesehen sowohl vorwärts als auch rückwärts erste Zusatzplatinen 9 (und gegebenenfalls auch zweite Zusatzplatinen 12) aufeinander folgen. Alternativ könnte die dritte Zusatzplatine 13 in der Erstreckungsrichtung x gesehen am Rand der Hauptplatine 8 angeordnet sein.

Schließlich ist aus den FIG 3 bis 6 ersichtlich, dass die Hauptplatine 8 in der Erstreckungsrichtung x gesehen hinter der ersten Zusatzplatine 9 der letzten Kaskadenhalbstufe 3 eine Zunge 14 aufweist, die sich in der Erstreckungsrichtung x von der genannten ersten Zusatzplatine 9 weg erstreckt. Einer der Ausgangsanschlüsse 2 ist an dem von dieser ersten Zusatzplatine 9 beabstandeten Ende der Zunge 14 angeordnet. Dieser Ausgangsanschluss 2 ist mit einem der Stufenausgänge 5 der letzten Kaskadenhalbstufe 3 verbunden.

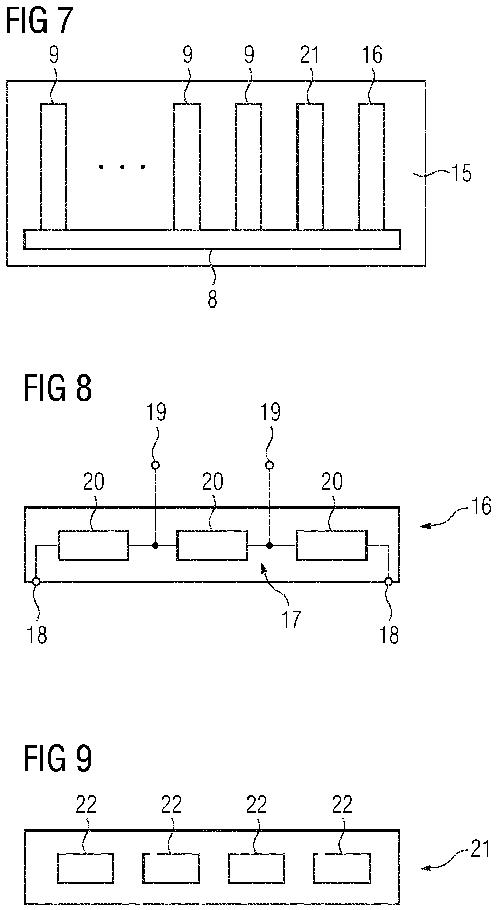

Gemäß FIG 7 weist die Hochspannungskaskade ein Ölbad 15 auf. In dem Ölbad 15 sind die Hauptplatine 8 und die ersten Zusatzplatinen 9 angeordnet. Meist besteht eine vollständige, hermetisch dichte Kapselung. Soweit vorhanden, sind in dem Ölbad 15 auch die zweiten Zusatzplatinen 12 und die dritte Zusatzplatine 13 angeordnet.

Gemäß FIG 7 kann die Hochspannungskaskade auch eine vierte Zusatzplatine 16 aufweisen. Wenn die vierte Zusatzplatine 16 vorhanden ist, ist sie ebenfalls mit der Hauptplatine 8 elektrisch und mechanisch verbunden, also auf der Hauptplatine 8 angeordnet.

Die vierte Zusatzplatine 16 trägt gemäß FIG 8 eine Teilerschaltung 17. Die Teilerschaltung 17 weist Messanschlüsse 18 auf. Je einer der Messanschlüsse 18 ist mit einem der Stufeneingänge 4 und einem der Stufenausgänge 5 verbunden. Es kann sich um einen Stufeneingang 4 und einen Stufenausgang 5 derselben Kaskadenhalbstufe 3 handeln. Es kann sich aber auch um einen Stufeneingang 4 und einen Stufenausgang 5 voneinander verschiedener Kaskadenhalbstufen 3 handeln. Die Teilerschaltung 17 weist weiterhin Ausgabeanschlüsse 19 auf. Über die Ausgabeanschlüsse 19 kann ein Bruchteil einer über die Messanschlüsse 18 abgegriffenen Kaskadenspannung als Messspannung abgegriffen werden. Das Verhältnis der Messspannung zur Kaskadenspannung ist durch die Widerstandswerte der Widerstände 20 der Teilerschaltung 17 bestimmt.

Die vierte Zusatzplatine 16 ist, sofern das Ölbad 15 vorhanden ist, ebenfalls in dem Ölbad 15 angeordnet. Die Ausgabeanschlüsse 19 sind jedoch in der Regel außerhalb des Ölbads 15 angeordnet.

In der Regel ist es ausreichend, wenn eine einzige vierte Zusatzplatine 16 vorhanden ist. Es können aber auch mehrere vierte Zusatzplatinen 16 vorhanden sein.

Gegebenenfalls kann die Hochspannungskaskade gemäß FIG 7 weiterhin auch eine fünfte Zusatzplatine 21 aufweisen. Wenn die fünfte Zusatzplatine 21 vorhanden ist, ist sie ebenfalls mit der Hauptplatine 8 elektrisch und mechanisch verbunden, also auf der Hauptplatine 8 angeordnet. Die fünfte Zusatzplatine 21 weist gemäß FIG 9 eine Schaltung von Bauelementen 22 auf. Über die Schaltung werden die Kondensatorschaltungen 6 entladen, sobald der Hochspannungskaskade über die Eingangsanschlüsse 1 nicht mehr die Eingangsspannung Ue zugeführt wird. Der prinzipielle Aufbau und die prinzipielle Funktionsweise einer derartigen Schaltung ist Fachleuten bekannt. Sie wird aufgrund ihrer Funktion oftmals als Lebensretterschaltung bezeichnet.

Die Hochspannungskaskade der vorliegenden Erfindung ist universell einsetzbar. Eine besonders bevorzugte Anwendung ist jedoch die Verwendung der Hochspannungskaskade für die elektrische Energieversorgung einer Röntgenröhre einer medizintechnischen Anlage, insbesondere einer C-Bogen-Anlage oder einer CT-Anlage.

Zusammengefasst betrifft die vorliegende Erfindung somit folgenden Sachverhalt:
Eine Hochspannungskaskade weist mehrere Kaskadenhalbstufen 3 auf, die jeweilige Stufeneingänge 4, jeweilige Stufenausgänge 5 und dazwischen eine jeweilige Kondensatorschaltung 6 und eine jeweilige Diodenschaltung 7 aufweisen. Die Stufeneingänge 4 der ersten Kaskadenhalbstufe 3 sind mit Eingangsanschlüssen 1 verbunden, über die der Hochspannungskaskade eine Eingangsspannung Ue zugeführt wird. Einer der Stufenausgänge 5 der letzten Kaskadenhalbstufe 3 ist mit einem von mehreren Ausgangsanschlüssen 2 verbunden, über die eine Ausgangsspannung Ua abgegeben wird. Im Übrigen sind die Stufenausgänge 5 einer jeweiligen Kaskadenhalbstufe 3 mit den Stufeneingängen 4 der jeweils nächsten Kaskadenhalbstufe 3 verbunden. Die Diodenschaltungen 7 sind auf ersten Zusatzplatinen 9 der Hochspannungskaskade angeordnet, die mit einer Hauptplatine 8 der Hochspannungskaskade elektrisch und mechanisch verbunden sind. Die ersten Zusatzplatinen 9 sind orthogonal zur Hauptplatine 8 orientiert und folgen entsprechend der elektrischen Abfolge der Kaskadenhalbstufen 3 in einer Erstreckungsrichtung x gesehen sequenziell aufeinander. Die ersten Zusatzplatinen 9 sind im Wesentlichen orthogonal zur Erstreckungsrichtung x orientiert. Die Kondensatorschaltungen 6 der Kaskadenhalbstufen 3 sind seitlich neben den ersten Zusatzplatinen 9 auf der Hauptplatine 8 angeordnet, und zwar entsprechend der elektrischen Abfolge der Kaskadenhalbstufen 3 und alternierend auf der einen und der anderen Seite der ersten Zusatzplatinen 9.

Die vorliegende Erfindung weist viele Vorteile auf. Insbesondere ergibt sich durch die Anordnung der Diodenschaltungen 7 auf den ersten Zusatzplatinen 9 eine sehr kompakte Bauweise. Weiterhin ergibt sich hierdurch auch ein modularer Aufbau. So kann beispielsweise - je nach Hauptplatine 8 - eine Hochspannungskaskade mit vier, sechs, acht usw. Kaskadenhalbstufen 3 realisiert werden. Auch können die ersten Zusatzplatinen 9 gegen andere erste Zusatzplatinen 9 ausgetauscht werden. Es können also nach Bedarf verschiedene Hauptplatinen 8 mit verschiedenen ersten Zusatzplatinen 9 mit oder ohne zweite Zusatzplatinen 12 verbaut werden. Aufgrund der zweiten Zusatzplatinen 12 ergibt sich weiterhin auf einfache Weise die Möglichkeit einer Feldsteuerung.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Hochspannungskaskade,
- wobei die Hochspannungskaskade Eingangsanschlüsse (1) aufweist, über die der Hochspannungskaskade eine Eingangsspannung (Ue) zugeführt wird, und Ausgangsanschlüsse (2) aufweist, über die eine Ausgangsspannung (Ua) abgegeben wird,
- wobei die Hochspannungskaskade mehrere Kaskadenhalbstufen (3) aufweist,
- wobei die Kaskadenhalbstufen (3) jeweilige Stufeneingänge (4), jeweilige Stufenausgänge (5) und zwischen den jeweiligen Stufeneingängen (4) und den jeweiligen Stufenausgängen (5) eine jeweilige Kondensatorschaltung (6) und eine jeweilige Diodenschaltung (7) aufweisen,
- wobei die Stufeneingänge (4) der ersten Kaskadenhalbstufe (3) mit den Eingangsanschlüssen (1) verbunden sind, einer der Stufenausgänge (5) der letzten Kaskadenhalbstufe (3) mit einem der Ausgangsanschlüsse (2) verbunden ist und im Übrigen die Stufenausgänge (5) einer jeweiligen Kaskadenhalbstufe (3) mit den Stufeneingängen (4) der jeweils nächsten Kaskadenhalbstufe (3) verbunden sind, so dass die Kaskadenhalbstufen (3) eine elektrische Abfolge von Kaskadenhalbstufen (3) bilden,
**dadurch gekennzeichnet,**
- **dass** die Diodenschaltungen (7) der Kaskadenhalbstufen (3) jeweils auf einer eigenen ersten Zusatzplatine (9) der Hochspannungskaskade angeordnet sind, die mit einer Hauptplatine (8) der Hochspannungskaskade elektrisch und mechanisch verbunden sind,
- **dass** die ersten Zusatzplatinen (9) orthogonal zur Hauptplatine (8) orientiert sind und entsprechend der elektrischen Abfolge der Kaskadenhalbstufen (3) in einer Erstreckungsrichtung (x) gesehen sequenziell aufeinander folgend angeordnet sind,
- **dass** die ersten Zusatzplatinen (9) im Wesentlichen orthogonal zur Erstreckungsrichtung (x) orientiert sind und
- **dass** die Kondensatorschaltungen (6) der Kaskadenhalbstufen (3) seitlich neben den ersten Zusatzplatinen (9) auf der Hauptplatine (8) angeordnet sind, und zwar entsprechend der elektrischen Abfolge der Kaskadenhalbstufen (3) und alternierend auf der einen und der anderen Seite der ersten Zusatzplatinen (9).

2. Hochspannungskaskade nach Anspruch 1,
**dadurch gekennzeichnet,**
**dass** die ersten Zusatzplatinen (9) auf der Hauptplatine (8) zickzackförmig angeordnet sind.

3. Hochspannungskaskade nach Anspruch 1 oder 2,
**dadurch gekennzeichnet,**
**dass** in die Hauptplatine (8) zwischen aufeinanderfolgenden ersten Zusatzplatinen (9) erste Ausnehmungen (10) eingebracht sind.

4. Hochspannungskaskade nach Anspruch 1, 2 oder 3,
**dadurch gekennzeichnet,**
**dass** in die Hauptplatine (8) im Bereich von Kondensatoren (6') der Kondensatorschaltungen (6) zweite Ausnehmungen (11) eingebracht sind, so dass die jeweilige zweite Ausnehmung (11) zwischen Anschlüssen des jeweiligen Kondensators (6') angeordnet ist.

5. Hochspannungskaskade nach einem der obigen Ansprüche,
**dadurch gekennzeichnet,**
**dass** die Hochspannungskaskade zweite Zusatzplatinen (12) aufweist, die mit der Hauptplatine (8) elektrisch und mechanisch verbunden sind, dass je eine der zweiten Zusatzplatinen (12) zwischen jeweils zwei aufeinander folgenden ersten Zusatzplatinen (9) angeordnet ist und dass die jeweilige zweite Zusatzplatine (12) mit einem Ausgangspotenzial der Kaskadenhalbstufe (3) verbunden ist, deren Bestandteil die jeweils vordere erste Zusatzplatine (9) ist.

6. Hochspannungskaskade nach Anspruch 5,
**dadurch gekennzeichnet,**
**dass** folgend auf die erste Zusatzplatine (9) der letzten Kaskadenhalbstufe (3) eine weitere zweite Zusatzplatine (12) angeordnet ist und dass die weitere zweite Zusatzplatine (12) mit einem Ausgangspotenzial der letzten Kaskadenhalbstufe (3) verbunden ist.

7. Hochspannungskaskade nach Anspruch 5 oder 6,
**dadurch gekennzeichnet,**
**dass** die zweiten Zusatzplatinen (12) orthogonal zur Erstreckungsrichtung (x) orientiert sind.

8. Hochspannungskaskade nach einem der obigen Ansprüche,
**dadurch gekennzeichnet,**
**dass** die Hochspannungskaskade eine dritte Zusatzplatine (13) aufweist, die mit der Hauptplatine (8) elektrisch und mechanisch verbunden ist, und dass die Eingangsanschlüsse (1) auf der dritten Zusatzplatine (13) angeordnet sind.

9. Hochspannungskaskade nach Anspruch 8,
**dadurch gekennzeichnet,**
**dass** die dritte Zusatzplatine (13) orthogonal zur Erstreckungsrichtung (x) orientiert ist.

10. Hochspannungskaskade nach einem der obigen Ansprüche,
**dadurch gekennzeichnet,**
**dass** die Hochspannungskaskade mindestens eine vierte Zusatzplatine (16) aufweist, die mit der Hauptplatine (8) elektrisch und mechanisch verbunden ist, dass die vierte Zusatzplatine (16) eine Teilerschaltung (17) trägt, dass die Teilerschaltung (17) Messanschlüsse (18) aufweist, die jeweils mit einem der Stufeneingänge (4) und einem der Stufenausgänge (5) verbunden sind und dass die Teilerschaltung (17) Ausgabeanschlüsse (19) aufweist, über die ein Bruchteil einer über die Messanschlüsse (18) abgegriffenen Kaskadenspannung als Messspannung abgreifbar ist.

11. Hochspannungskaskade nach einem der obigen Ansprüche,
**dadurch gekennzeichnet,**
**dass** die Hochspannungskaskade mindestens eine fünfte Zusatzplatine (21) aufweist, die mit der Hauptplatine (8) elektrisch und mechanisch verbunden ist, und dass die fünfte Zusatzplatine (21) eine Schaltung von Bauelementen (22) aufweist, über welche die Kondensatorschaltungen (6) entladen werden, sobald der Hochspannungskaskade über die Eingangsanschlüsse (1) nicht mehr die Eingangsspannung (Ue) zugeführt wird.

12. Hochspannungskaskade nach einem der obigen Ansprüche,
**dadurch gekennzeichnet,**
**dass** die Hochspannungskaskade ein Ölbad (15) aufweist, in dem die Hauptplatine (8) und die ersten Zusatzplatinen (9) angeordnet sind.

13. Hochspannungskaskade nach einem der obigen Ansprüche,
**dadurch gekennzeichnet,**
**dass** die Hauptplatine (8) in der Erstreckungsrichtung (x) gesehen hinter der ersten Zusatzplatine (9) der letzten Kaskadenhalbstufe (3) eine sich in der Erstreckungsrichtung (x) erstreckende Zunge (14) aufweist und dass einer der Ausgangsanschlüsse (2) an dem von der ersten Zusatzplatine (9) der letzten Kaskadenhalbstufe (3) beabstandeten Ende der Zunge (14) angeordnet ist.

14. Hochspannungskaskade nach einem der obigen Ansprüche,
**dadurch gekennzeichnet,**
**dass** die Hochspannungskaskade für die elektrische Energieversorgung einer Röntgenröhre einer medizintechnischen Anlage verwendet wird, insbesondere einer C-Bogen-Anlage oder einer CT-Anlage.
